# FASCICULE DE BREVET EUROPEEN

(11) **EP 0 881 690 B1**
(45) Date de publication et mention de la délivrance du brevet: **25.08.2010**
(21) Numéro de dépôt: 98401206.2
(22) Date de dépôt: 19.05.1998
(51) Int. Cl.: H01L 29/737, H01L 21/331

(54) **Procédé de réalisation d'un transistor bipolaire stabilisé avec éléments isolants électriques**
Verfahren zur Herstellung eines Wertbeständigen Bipolartransistors mit elektrisch isolierenden Elementen
Process for fabricating a stabilized bipolar transistor with electric insulating elements

(30) Priorité: 30.05.1997 FR 9706682
(43) Date de publication de la demande: 02.12.1998
(73) Titulaire: Thales, 75008 Paris (FR)
(72) Inventeur: Delage, Sylvain, Thomson-CSF Prop. Intel., 94117 Arcueil cedex (FR); Cassette, Simone, Thomson-CSF Prop. Intel., 94117 Arcueil cedex (FR); Henkel, Achim, Thomson-CSF Prop. Intel., 94117 Arcueil cedex (FR); Salzenstein, Patrice, Thomson-CSF Prop. Intel., 94117 Arcueil cedex (FR)
(74) Mandataire: Guérin, Michel

(56) Documents cités:
- EP-A- 0 188 897
- EP-A- 0 430 086
- EP-A- 0 559 182
- EP-A- 0 752 723
- EP-A- 0 756 322
- US-A- 5 332 912
- US-A- 5 436 181
- Y. KAMIYA ET AL.: "The electrical characteristics of boron-implanted InP" JOURNAL OF THE ELECTROCHEMICAL SOCIETY., vol. 133, no. 4, avril 1986, pages 780-784, XP002054770 MANCHESTER, NEW HAMPSHIRE US

## Description

Le domaine de l'invention est celui des transistors bipolaires et notamment des transistors bipolaires à hétérojonction, à structure verticale, dans lesquels le courant est transporté perpendiculairement à la surface du substrat, utilisés pour des applications hyperfréquences.

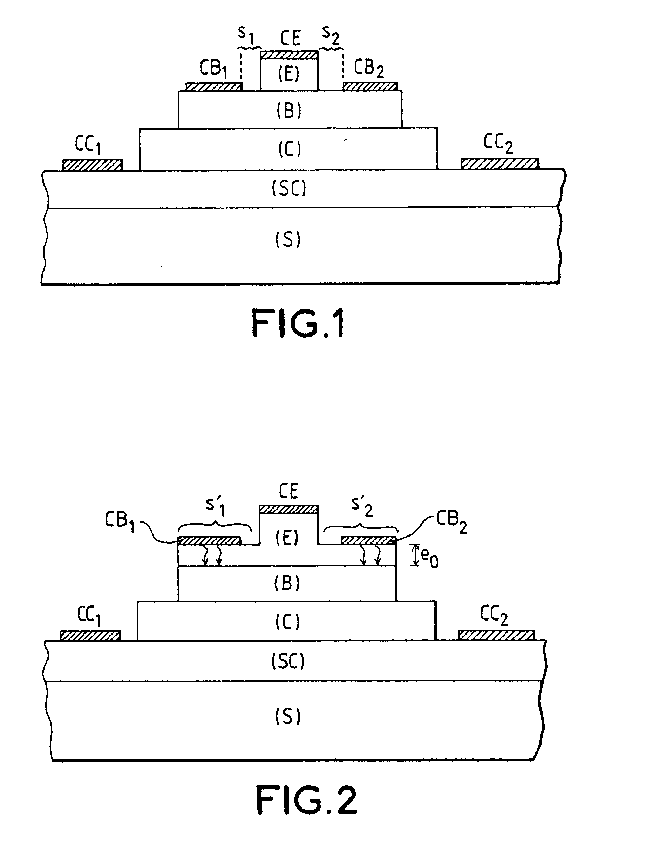

Ils sont constitués d'un empilement de couches de matériaux semiconducteurs, dont au moins une couche superficielle est gravée en mesa, c'est-à-dire forme un motif en relief. La figure 1 illustre une structure classique de transistor bipolaire à hétérojonction dits HBT comprenant un substrat S, un sous-collecteur SC, un collecteur C, une base B et un émetteur E. Classiquement, un contact CE est réalisé à la surface de l'émetteur par superposition de couches adaptées. Latéralement, deux contacts CB₁ et CB₂ sont également réalisés au niveau du collecteur de part et d'autre de la base.

Ce type de structure verticale pose un problème de recombinaisons électrons/trous, au niveau des surfaces libres S₁ et S₂ illustrées en figure 1, ces recombinaisons jouant un rôle majeur dans la dégradation de gain en courant.

Ce phénomène étant d'autant plus important que les transistors sont de petites tailles, les phénomènes de recombinaison de surface prenant une part plus importante, les applications en hyperfréquence de telles structures sont fortement pénalisées par ce problème. En effet, pour un fonctionnement en hyperfréquence, un transistor bipolaire consiste en plusieurs transistors élémentaires (encore appelés doigts) mis en parallèle. Pour limiter la résistance de base, il convient de limiter la largeur de l'émetteur et donc de chaque doigt. Typiquement, la largeur d'un doigt peut être de l'ordre de 2 µm pour des applications à des fréquences inférieures à 100 GHz, alors que la longueur du doigt d'émetteur peut être d'une trentaine de microns.

Certaines solutions ont déjà été apportées à ce problème et notamment dans le cadre des transistors HBT élaborés avec des matériaux GaAlAs/GaAs. Ainsi, il a été envisagé d'introduire une couche de passivation formée en laissant à la surface entre l'émetteur et la base, un matériau semiconducteur de grande bande interdite très fin et donc dépeuplé qui évite l'apparition de défauts électriques recombinants à l'interface base/passivation. Plus précisément, la figure 2 décrit une structure dans laquelle l'émetteur E possède une architecture particulière obtenue par gravure partielle d'une couche de GaAlAs, déposée sur une couche de GaAs constituant la base B. Deux contacts CB₁ et CB₂ sont réalisés au niveau de la couche émettrice sur des surfaces S'1 et S'2, puis par un traitement adapté, ces contacts peuvent diffuser sur l'épaisseur eₒ. Dans cette configuration, les recombinaisons électrons/trous dans la base, favorisées antérieurement au niveau de la surface libre de la base, sont limitées en raison de l'épaisseur eₒ d'émetteur, maintenue au-dessus de la base. Le problème de ce type de structure réside cependant dans leur mauvaise stabilité, dans la mesure où la diffusion réalisée pour les contacts ne peut être entièrement maîtrisée et peut donc ainsi continuer à évoluer avec le temps et la température.

C'est pourquoi, l'invention propose un procédé de réalisation d'un transistor bipolaire à hétérojonction dans lequel les recombinaisons de surface sont minimisées grâce à des éléments isolants électriques situés sur une partie de la base et en contact direct avec les flancs de la mesa émetteur.

L'invention s'applique aussi bien aux structures dans lesquelles la mesa est une mesa « émetteur » qu'aux structures dans lesquelles la mesa est une mesa « collecteur ». Le document brevet US 5 436 181 décrit un procédé de réalisation d'un transistor bipolaire à hétérojonction en matériaux III-V, comprenant une implantation ionique pour former des zones II-lartes.

Plus précisément l'invention a pour objet un procédé de réalisation d'un transistor bipolaire à hétérojonction à base de matériaux semiconducteurs III-V comprenant un collecteur, une base, un émetteur et présentant une mesa située sur la base, caractérisé en ce qu'il comprend en outre des éléments isolants électriques en contact avec la surface libre de la base et en contact avec les flancs de la mesa, la largeur desdits éléments étant du même ordre de grandeur que la largeur de ladite mesa.

Selon une variante de l'invention, la mesa est une mesa d'émetteur à base de Gaₓln₁₋ₓP dopé p, la base est constituée de Gayln_{1-y}As, les éléments isolants électriques étant constitués de Gaₓln₁₋ₓP contenant des ions de Bore.

Avantageusement, la mesa peut comprendre en surface, une couche de contact ohmique en métal réfractaire de type TiWSi, WN, TiW...

Selon une variante de l'invention, le transistor bipolaire comprend une couche de passivation.

Selon une variante de l'invention, le transistor bipolaire comprend un drain thermique en forme de pont reposant d'une part sur la mesa, d'autre part sur le substrat.

L'invention a aussi pour objet un procédé de réalisation d'un transistor bipolaire à hétérojonction à base de matériaux semiconducteurs III-V comprenant la croissance épitaxiale de couches semiconductrices dont une couche dopée de type p (ou n) et constitutive de la base est comprise entre deux couches dopées de type n (ou p) et constitutives de l'émetteur et du collecteur, caractérisé en ce qu'il comprend en outre :
- l'implantation ionique à travers un masque de largeur l, d'ions isolant électriquement dans la couche dite supérieure, située au-dessus de la couche de base ;
- la gravure à travers un masque de largeur L supérieure à la largeur l, de la couche rendue localement isolante électriquement, de manière à définir des éléments isolants électriques (61) de part et d'autre d'éléments semiconducteurs dopés (40).

Avantageusement, les couches dites supérieure et de base ont des comportements différents vis-à-vis de l'implantation ionique, seule la couche dite supérieure a ses propriétés électriques modifiées par ladite implantation ionique.

L'invention sera mieux comprise et d'autres avantages apparaîtront à la lecture de la description qui va suivre, donnée à titre non limitatif et grâce aux figures annexées par lesquelles :
- la figure 1 illustre une structure classique de transistor bipolaire à hétérojonction ;
- la figure 2 illustre une structure de transistor bipolaire à hétérojonction selon l'art antérieur dans laquelle une architecture particulière de mesa émetteur permet de limiter les recombinaisons électrons/trous ;
- la figure 3 illustre un transistor bipolaire à hétérojonction
   ;
- la figure 4 illustre l'évolution de la résistivité du GaInP dopé n, constitutif d'une couche « émetteur » dans un transistor en fonction d'une dose d'ions Bore dans une étape d'implantation ionique ;
- la figure 5 illustre l'évolution de la résistivité du GaAs dopé p, constitutif d'une couche de base dans un transistor , en fonction d'une dose d'ions Bore, dans une étape d'implantation ionique ;
- les figures 6a, 6b, 6c, 6d, 6e et 6f illustrent les principales étapes d'un procédé de fabrication d'un transistor selon l'invention ;
- la figure 7 illustre un exemple de transistor bipolaire comprenant une couche de passivation ;
- la figure 8 illustre un premier exemple de transistor bipolaire comprenant un drain thermique reposant notamment sur le masque de largeur l.
- la figure 9 illustre un second exemple de transistor bipolaire comprenant un drain thermique reposant sur la mesa sans masque de largeur l.

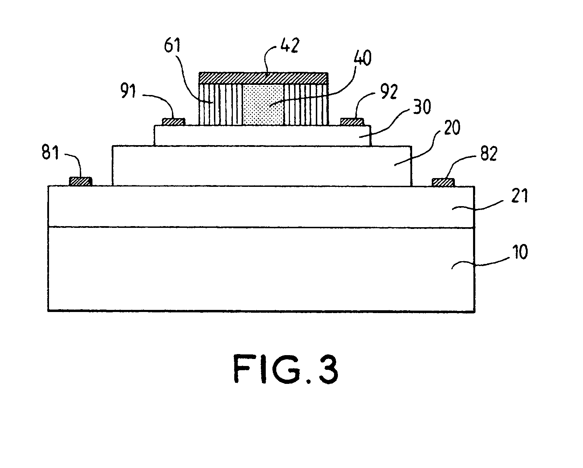

Un transistor bipolaire à hétérojonction est schématisé en figure 3, dans le cas d'un émetteur en haut (il est à noter que l'invention s'applique aussi dans le cas de structure présentant un collecteur en haut). Ce transistor bipolaire comprend un substrat 10, un sous-collecteur 21, un collecteur 20, une base 30 et un émetteur 40. Des contacts ohmiques 81 et 82 de collecteur sont situés sur la couche de sous-collecteur 21, des contacts ohmiques 91, 92 de base sont situés sur la base, de part et d'autre de la mesa émetteur 40, dont les flancs sont en contact avec des éléments isolants électriques 61. Un contact ohmique émetteur 42 est situé sur l'ensemble de la mesa 40 et des éléments isolants 61.

L'invention va être plus précisément décrite dans le cadre des transistors bipolaires à hétérojonction Ga_{0,5}In_{0,5}P/GaAs, npn. Le choix d'un matériau à base de phosphore et d'un matériau à base d'arsenic permet d'obtenir un comportement vis-à-vis d'opérations telles que la gravure ou l'implantation ionique, différent et sélectif d'une couche à l'autre, ce qui revêt un intérêt prépondérant dans le cadre de l'invention.

Ce type de transistor comprend :
- un substrat semi-isolant en GaAs ;
- une couche de sous-collecteur en GaAs dopée n (concentration typiquement de l'ordre de 4.10¹⁸cm⁻³) ;
- une couche de collecteur en GaAs dopée n (concentration typiquement de l'ordre de 2.10¹⁶cm⁻³) ;
- une couche de base en GaAs dopée p (concentration typiquement de l'ordre de 7.10¹⁹cm⁻³) ;
- une couche d'émetteur en GaInP dopée n (concentration typiquement 3.10¹⁷cm⁻³).

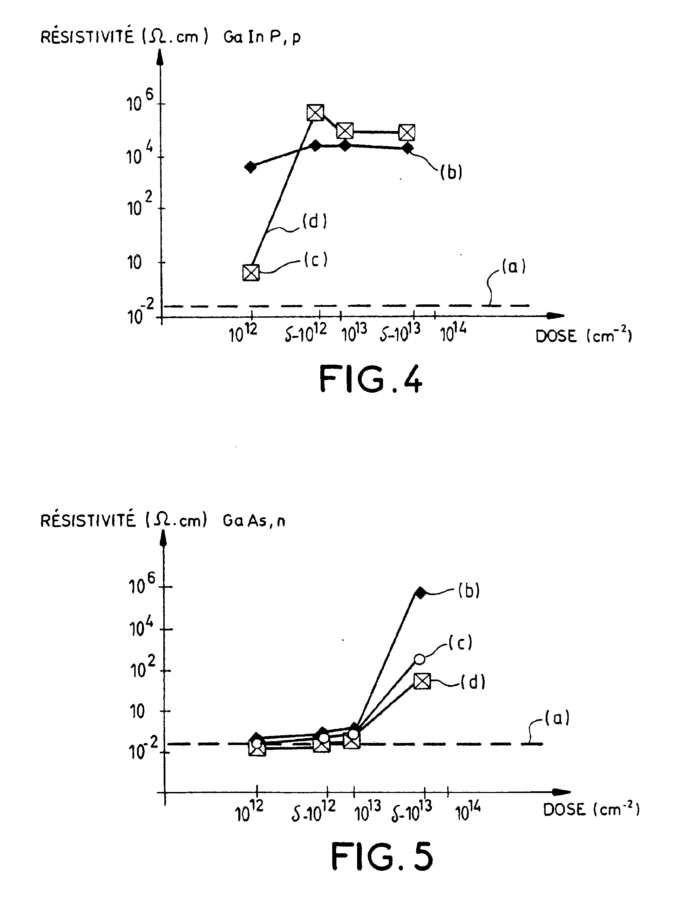

On définit de manière bien contrôlée des mesa émetteur GaInP par gravure sélective sur GaAs, de même les matériaux GaInP et GaAs présentent des comportements très différents vis-à-vis d'implantation ionique comme l'illustrent les courbes des figures 4 et 5.

Les courbes (a), (b), (c) et (d) sont respectivement relatives à des mesures effectuées avant, pendant, 10 minutes après et 1 heure après, implantation ionique.

Les figures 4 et 5 montrent la différence de sensibilité de la conductivité électrique (respectivement) du GaInP dopé n et du GaAs dopé p, à l'implantation de Bore à 200 kV en fonction de la dose d'ions déposée. Cette évolution est suivie en fonction du temps de recuit à 416°C. Dans le cas du GaInP de type n, le matériau présente une résistivité électrique supérieure à 10⁵Ω.cm pour des doses d'implantation de 5.10¹²cm⁻². Ce phénomène permet de rendre des couches de GaInP dopée n, pratiquement isolante de manière à définir les éléments 61 évoqués précédemment, alors que dans le même temps, une couche de GaAs dopée p, conserve pratiquement la même résistivité électrique.

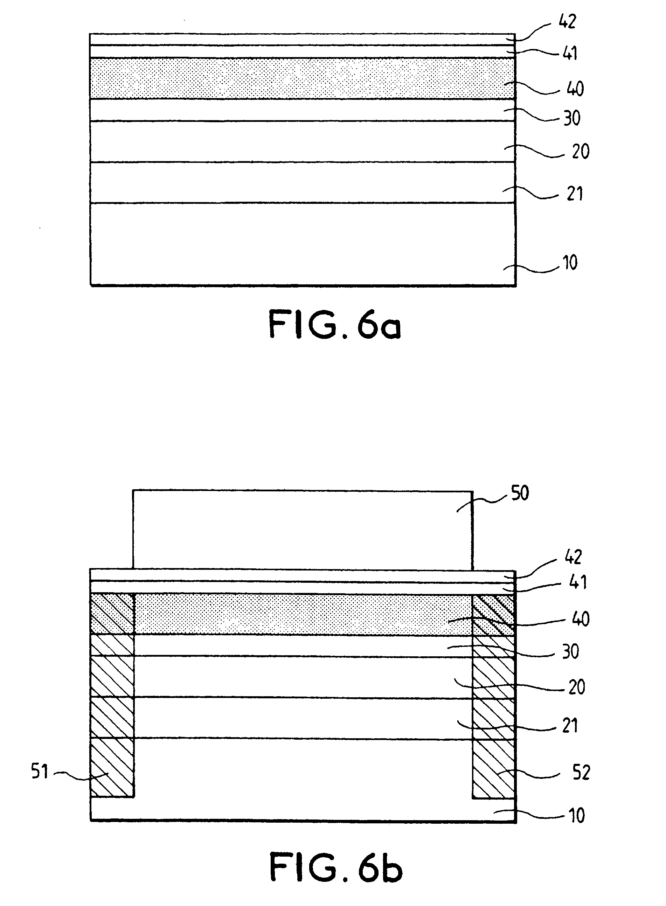

Nous allons décrire plus en détails, le procédé de fabrication selon l'invention permettant d'obtenir un tel transistor à hétérojonction. Ce procédé comprend les principales étapes illustrées sur les figures 6a à 6f.

A partir d'un substrat 10 de GaAs on réalise la croissance épitaxiale de couches suivantes :
- une couche 21 de sous-collecteur (GaAs dopé n) ;
- une couche 20 de collecteur (GaAs dopé n) ;
- une couche 30 de base (GaAs dopé p) ;
- une couche 40 d'émetteur (GaInP dopé n) ;
- une couche 41 de contact (GaInAs) ;

Une couche 42 métallique réfractaire (TiWSi, WN ; TiW ...) est déposée ex-situ afin d'assurer le contact ohmique réfractaire.

Un avantage important de l'utilisation d'un matériau réfractaire provient de la possibilité de recuire la structure après la définition de la mesa d'émetteur (décrite ci-après), afin de faciliter l'évacuation de l'hydrogène piégé essentiellement dans la couche semiconductrice de base au cours de l'épitaxie. En effet, le métal réfractaire permet de supporter les températures élevées nécessaires au dépiégeage de l'hydrogène. Il est à noter que la présence de la mesa augmente la probabilité d'exodiffusion de l'hydrogène piégé sur les atomes accepteurs de base qui sont confinés dans le puits de potentiel engendré par les jonctions métallurgiques. L'empilement de couches, ainsi réalisé, est illustré en figure 6a.

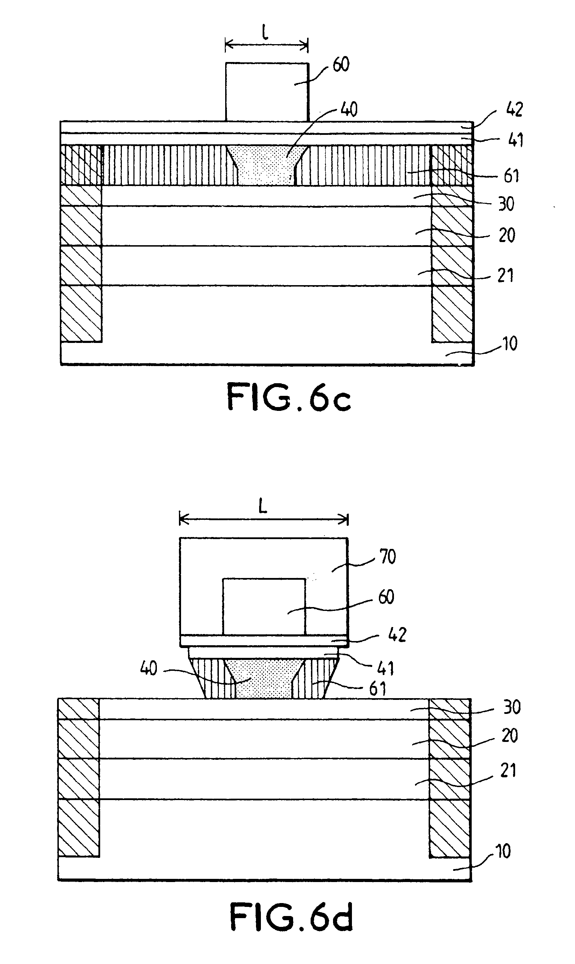

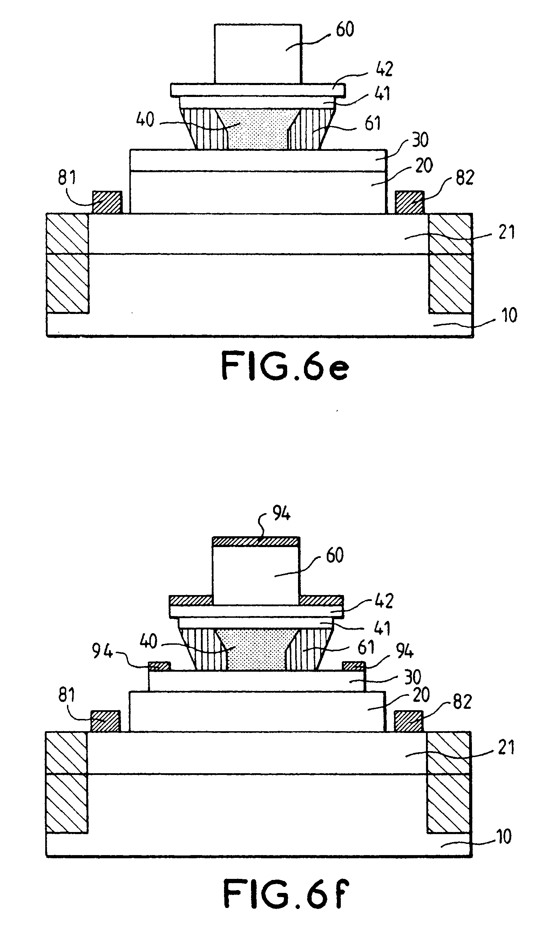

Dans un second temps, de manière à isoler les transistors bipolaires, réalisés de manière collective à partir d'un substrat commun, on réalise des masques 50 de protection d'implantation en résine et l'on procède à une étape d'implantation ionique profonde d'isolation électrique (H, He, B, O, F, ...) afin de diminuer les parasites du composant et de réaliser l'isolation inter-composants, au moyen de caissons d'isolation 51 et 52 (figure 6b).
- Puis on procède au dépôt d'une métallisation d'épaississement 60 de largeur l, du contact ohmique d'émetteur par procédé lift-off classique, puis à l'implantation ionique de passivation sélective au Bore à 200 kV, de manière à définir les régions isolantes 61 dans la couche d'émetteur 40. L'étape d'implantation conduit de manière inhérente à la mesa rentrante 40 illustrée en figure 6c. La métallisation 60 peut être en Ti/Au, d'une largeur typiquement de 2 µm et d'une épaisseur d'environ 1 µm. Du fait de la présence de la métallisation sur l'émetteur, les matériaux semiconducteurs protégés par ce masque voient leur conductivité électrique initiale préservée. L'épaisseur de la métallisation en réfractaire est suffisamment fine pour permettre aux ions de la traverser sans perte majeure d'énergie. La dose d'implantation de Bore est de 2,5 10¹²cm⁻² si bien que seule la couche de GaInP exposée est rendue isolante. La queue de distribution des ions traverse la base sans la perturber du fait de la faible sensibilité de ce matériau à l'implantation. En revanche, le collecteur en GaAs de type n faiblement dopé (de l'ordre de 2.10¹⁶cm⁻³) peut être légèrement modifié électriquement par cette queue de distribution sans inconvénient majeur.
- On réalise un second masque de gravure en résine photosensible 70, de largeur L. On procède à la gravure sèche par gravure ionique réactive à base de SF₆ du métal réfractaire, puis à la gravure de la couche 41 de GaAs par gravure ionique réactive à base de SiCl₄ et de la couche 61 de GaInP implanté au Bore en gravure chimique à base de HCl, Typiquement, la couche de GaAs peut être gravée par gravure ionique réactive chlorée telle que SiCl₄ ou bien par voie humide à l'aide d'acide citrique par exemple. Le GaInP peut être gravé à l'aide de solution à base d'acide chlorhydrique pur ou dilué. On définit ainsi des éléments isolants électriques 61 de part et d'autre de la mesa émetteur 40, comme l'illustre la figure 6d. Les éléments isolants électriques peuvent typiquement avoir une largeur de l'ordre d'au moins 0,3 µm pour passiver efficacement la base. La largeur de 1 µm permet de trouver un compromis efficace afin de réaliser des composants fonctionnant en hyperfréquence. Le gain hyperfréquence chute en effet d'environ 1dB à 10 GHz par micron d'espacement entre la zone active d'émetteur et le bord du ruban du contact ohmique de base du fait de l'augmentation de la résistance d'accès de la base et de la capacité base-collecteur.
- Dans une étape ultérieure illustrée en figure 6e, on procède à la gravure de la mesa de base par voie sèche (RIE chlorée), ou mixte (RIE puis chimique), suivie de la réalisation des contacts ohmiques de collecteur 81 et 82.
- Puis on procède à la réalisation des contacts ohmiques de base autoalignés, matérialisés par une couche métallique 94, par rapport à la mesa de l'émetteur suivie de la gravure de la base extrinsèque afin de diminuer la capacité parasite base-collecteur comme illustré en figure 6f. La métallisation du contact ohmique peut être réalisée par exemple avec un
alliage Ti/Pt/Au ou Mo/Au. L'utilisation d'une métallisation ne contenant pas de Pt ou de Pd peut éviter l'apparition de réaction catalytique avec l'hydrogène moléculaire ambiant. Le surplomb de l'ordre de 0.1 µm facilement obtenu sous le métal réfractaire (dans le cas de la gravure humide de la couche supérieure à base de composés arséniés) permet une métallisation de base épaisse ce qui est favorable au fonctionnement hyperfréquence du composant, en limitant les phénomènes propagatifs à haute fréquence dans les rubans de la base.

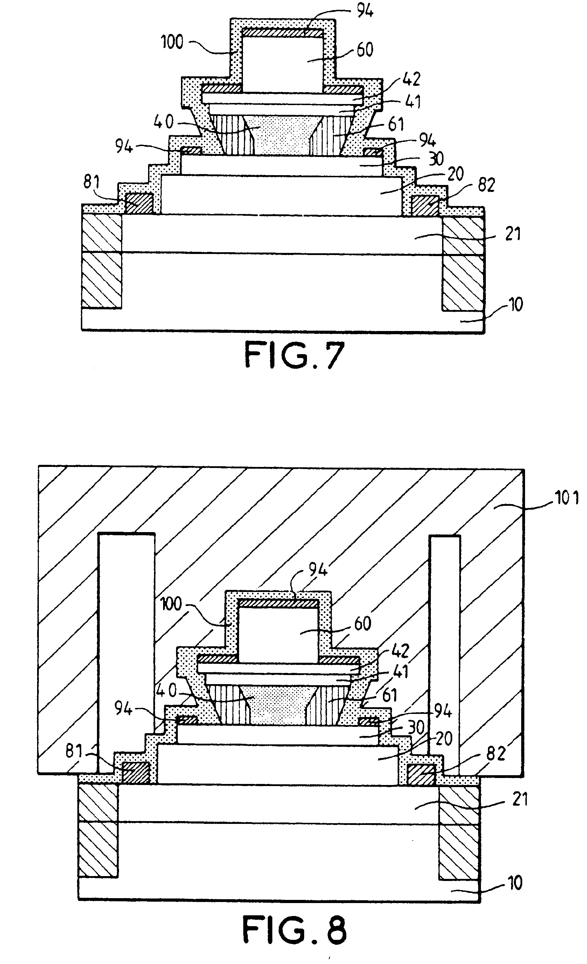

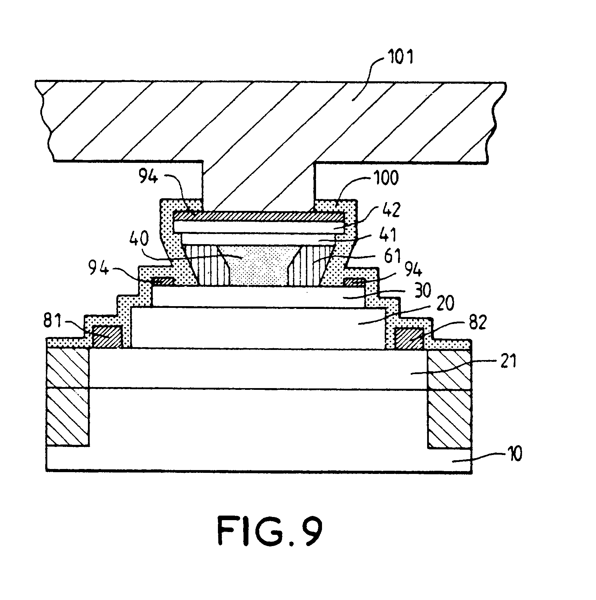

Ce procédé et le composant qui en découle présentent un certain nombre d'avantages dont les suivants :
- les éléments épais 61 assurent une passivation épaisse et donc une excellente stabilité à long terme ;
- l'utilisation d'un métal réfractaire 42 permet d'envisager un retrait plus aisé de l'hydrogène présent dans la base après la définition de la mesa d'émetteur et donc permet d'accroître la fiabilité du dispositif ;
- le procédé précédemment décrit reste compatible avec la présence d'une couche de passivation fine plus classique ainsi qu'avec la présence d'une résistance de ballast intégrée dans la couche d'émetteur telle que décrite dans la demande de brevet publiée sous le n° FR-A-2 736 468 et déposée par la demanderesse. Un exemple de transistor selon l'invention comportant une couche de passivation 100 est illustré en figure 7;
- le composant obtenu est compatible avec la réalisation de drain thermique supérieur tel que décrit dans la demande de brevet français publiée sous le n° FR-A-2 737 342 et déposée par la demanderesse. Un exemple de composant selon l'invention comportant une couche de passivation 100 et un drain thermique 101 est illustré en figure 8. Dans la description précédente, l'élément de masque 60 est un élément métallique. Cet élément de masque peut également être en résine et supprimé ultérieurement. Dans ce cas, le drain thermique peut reposer directement sur la couche 94 de contact au niveau de l'émetteur. En effet, la largeur totale de l'ensemble mesa 40/éléments 61, soit la dimension L est suffisante pour dégager localement la couche de passivation 100 et faire reposer directement le drain thermique sur la couche 94, comme illustré en figure 9.

## Revendications

1. Procédé de réalisation d'un transistor bipolaire à hétérojonction à base de matériaux semiconducteurs III-V comprenant la croissance épitaxiale de couches semiconductrices dont une couche dopée de type p (ou n) et constitutive de la base est comprise entre deux couches dopées de type n (ou p) et constitutives de l'émetteur et du collecteur, **caractérisé en ce qu'**il comprend en outre :
- l'implantation ionique, d'ions isolant électriquement dans la couche dite supérieure située au-dessus de la couche de base afin de rendre isolante ladite couche supérieure, une partie de ladite couche supérieure étant protégée de l'implantation par un masque de largeur I (60) et la couche de base étant formée dans un matériau non rendu isolant par l'implantation des ions rendant isolante la couche dite supérieure ;
- la gravure de la couche rendue isolante, une partie de ladite couche rendue isolante étant protégée de la gravure par un masque de largeur L (70) supérieure à la largeur I, de manière à définir des éléments isolants électriques (61) de part et d'autre d'éléments semiconducteurs dopés (40).

2. Procédé de réalisation d'un transistor bipolaire selon la revendication 1, **caractérisé en ce que** la couche située au-dessus de la couche de base est en Gaₓln₁₋ₓP dopée n, la couche de basé est en Ga_{yl}n_{1-y} As dopée p.

3. Procédé de réalisation d'un transistor bipolaire selon l'une des revendications 1 ou 2, **caractérisé en ce que** le masque de largeur I (60) est en métal de type Ti/Au.

4. Procédé de réalisation d'un transistor bipolaire selon l'une des revendications 1 ou 2, **caractérisé en ce que** le masque de largeur I (60) est en résine.

5. Procédé de réalisation d'un transistor bipolaire selon l'une des revendications 1 à 4, **caractérisé en ce que** la largeur de chaque élément isolant électrique (61) est voisine du micron, la largeur de la mesa étant voisine de deux microns.

6. Procédé de réalisation d'un transistor bipolaire selon l'une des revendications 1 à 5, **caractérisé en ce que** la mesa est une mesa d'émetteur constituée de GaₓIn₁₋ₓP dopé n, la base est constituée de Ga_{y}In_{1-y} As dopée p, les éléments isolants électriques étant constitués de GaₓIn₁₋ₓP contenant du Bore.

7. Procédé de réalisation d'un transistor bipolaire selon l'une des revendications 1 à 6, **caractérisé en ce que** la mesa comprend en surface une couche de contact ohmique en métal réfractaire de type TiWSi, WN, TiW.

8. Procédé de réalisation d'un transistor bipolaire à hétérojonction selon l'une des revendications 1 à 7, **caractérisé en ce que** le transistor comprend en outre une couche de passivation (100) recouvrant l'ensemble du relief du transistor.

9. Procédé de réalisation d'un transistor bipolaire selon l'une des revendications 1 à 8, **caractérisé en ce que** le transistor comprend en outre un drain thermique (101) en forme de pont reposant d'une part sur la mesa, d'autre part sur le substrat.

## Claims

1. Method for manufacturing a heterojunction bipolar transistor based on III-V semiconductor materials including the epitaxial growth of semiconductor layers, of which a p type (or n type) doped layer constituting the base is between two n type (or p type) doped layers constituting the emitter and the collector, **characterised in that** said method further includes:
- the ion implantation of electrically insulating ions in what is known as the upper layer located above the base layer in order to make said upper layer insulating, a part of said upper layer being protected from the implantation by a mask of width 1 (60) and the base layer being made of a material which has not been made insulating by the implantation of the ions making what is known as the upper layer insulating;
- the etching of the layer which has been made insulating, a part of said layer made insulating being protected from the etching by a mask of width L (70) which is greater than the width 1, so as to define electric insulating elements (61) on either side of doped semiconductor elements (40).

2. Method for manufacturing a bipolar transistor according to claim 1, **characterised in that** the layer located above the base layer is made of n doped Gaₓ In₁₋ₓ P, the base layer is made ofp doped Ga_{y} In_{1-y} As.

3. Method for manufacturing a bipolar transistor according to one of claims 1 or 2, **characterised in that** the mask of width 1 (60) is made of Ti/Au type metal.

4. Method for manufacturing a bipolar transistor according to one of claims 1 or 2, **characterised in that** the mask of width 1 (60) is made of resin.

5. Method for manufacturing a bipolar transistor according to one of claims 1 to 4, **characterised in that** the width of each electrical insulating element (61) is about one micron, the width of the mesa being about two microns.

6. Method for manufacturing a bipolar transistor according to one of claims 1 to 5, **characterised in that** the mesa is an emitter mesa consisting of n doped Gaₓ In₁₋ₓ P, the base consists of p doped Ga_{y} In_{1-y} As, the electric insulating elements consisting of Gaₓ In₁₋ₓ P containing boron.

7. Method for manufacturing a bipolar transistor according to one of claims 1 to 6, **characterised in that** the mesa comprises, on the surface, an ohmic contact layer made of refractory metal of the TiWSi, WN, TiW type.

8. Method for manufacturing a heterojunction bipolar transistor according to one of claims 1 to 7, **characterised in that** the transistor further comprises a passivation layer (100) covering the entire relief of the transistor.

9. Method for manufacturing a bipolar transistor according to one of claims 1 to 8, **characterised in that** the bipolar transistor further comprises a heat sink (101) in the form of a bridge lying on the one hand on the mesa and on the other hand on the substrate.

## Patentansprüche

1. Verfahren zur Herstellung eines bipolaren Transistors mit Heteroübergang auf der Basis von Halbleitermaterialien III-V, das das epitaxiale Wachstum von Halbleiterschichten beinhaltet, wovon eine die Basis bildende p- (oder n-) dotierte Schicht zwischen zwei n- (oder p-) dotierten und den Emitter und den Kollektor bildenden Schichten eingeschlossen ist, **dadurch gekennzeichnet, dass** es darüber hinaus Folgendes beinhaltet:
- die ionische Implantation von elektrisch isolierenden Ionen in die sogenannte obere Schicht, die über der Basisschicht liegt, um die obere Schicht isolierend zu machen, wobei ein Teil der oberen Schicht vor der Implantation durch eine Maske der Breite 1 (60) geschützt wird und die Basisschicht aus einem Material gebildet ist, das nicht durch die Implantation der Ionen isolierend gemacht wurde, die die obere Schicht isolierend machen;
- das Ätzen der isolierend gemachten Schicht, wobei ein Teil der isolierend gemachten Schicht vor dem Ätzen durch eine Maske der Breite L (70) geschützt wird, die größer ist als die Breite 1, um elektrisch isolierende Elemente (61) auf beiden Seiten von dotierten Halbleiterelementen (40) zu definieren.

2. Verfahren zur Herstellung eines bipolaren Transistors nach Anspruch 1, **dadurch gekennzeichnet, dass** die Schicht über der Basisschicht aus n-dotiertem GaₓIn₁₋ₓP ist und die Basisschicht aus p-dotiertem Ga_{y}In_{l-y}As ist.

3. Verfahren zur Herstellung eines bipolaren Transistors nach Anspruch 1 oder 2, **dadurch gekennzeichnet, dass** die Maske der Breite 1 (60) aus Metall des Typs Ti/Au ist.

4. Verfahren zur Herstellung eines bipolaren Transistors nach Anspruch 1 oder 2, **dadurch gekennzeichnet, dass** die Maske der Breite 1 (60) aus Harz ist.

5. Verfahren zur Herstellung eines bipolaren Transistors nach einem der Ansprüche 1 bis 4, **dadurch gekennzeichnet, dass** die Breite jedes elektrisch isolierenden Elementes (61) bei etwa einem Mikron liegt und die Breite der Mesa bei etwa zwei Mikron liegt.

6. Verfahren zur Herstellung eines bipolaren Transistors nach einem der Ansprüche 1 bis 5, **dadurch gekennzeichnet, dass** die Mesa eine aus n-dotiertem GaₓIn₁₋ₓP gebildete Emitter-Mesa ist, die Basis aus p-dotiertem Ga_{y}In_{l-y}As gebildet ist, die elektrisch isolierenden Elemente aus Bor enthaltendem GaₓIn₁₋ₓP gebildet sind.

7. Verfahren zur Herstellung eines bipolaren Transistors nach einem der Ansprüche 1 bis 6, **dadurch gekennzeichnet, dass** die Mesa als Oberfläche eine ohmsche Kontaktschicht aus hitzebeständigem Metall des Typs TiWSi, WN, TiW umfasst.

8. Verfahren zur Herstellung eines bipolaren Transistors mit Heteroübergang nach einem der Ansprüche 1 bis 7, **dadurch gekennzeichnet, dass** der Transistor darüber hinaus eine Passivierungsschicht (100) umfasst, die das gesamte Relief des Transistors bedeckt.

9. Verfahren zur Herstellung eines bipolaren Transistors nach einem der Ansprüche 1 bis 8, **dadurch gekennzeichnet, dass** der Transistor darüber hinaus eine Wärmesenke (101) in Form einer Brücke umfasst, die einerseits auf der Mesa und andererseits auf dem Substrat ruht.
